(19) Europäisches Patentamt
European Patent Office
Office européen des brevets

(11) **EP 1 148 638 B1**

(12) **EUROPEAN PATENT SPECIFICATION**

(45) Date of publication and mention
of the grant of the patent:
**21.09.2005 Bulletin 2005/38**

(51) Int Cl.⁷: **H03G 3/34**

(21) Application number: **00107543.1**

(22) Date of filing: **07.04.2000**

(54) **Receiver with audio mute switch controlled by field strength analyzer**

Empfänger mit Audiostummschalter gesteuert durch Feldstärkenanlyse

Poste de réception avec commutateur silencieux commandé par analyse de l'intensité de champs

(84) Designated Contracting States:
**DE FR GB**

(43) Date of publication of application:
**24.10.2001 Bulletin 2001/43**

(73) Proprietor: **MOTOROLA, INC.**
**Schaumburg, IL 60196 (US)**

(72) Inventors:
• **Lichterfeld, Stefan**
**65232 Taunusstein (DE)**
• **Hammes, Bernhard**
**65329 Hohenstein (DE)**
• **Koenig, Hartmut**
**65232 Taunusstein (DE)**

(74) Representative: **McCormack, Derek James et al**
**Optimus,**
**Grove House,**
**Lutyens Close,**
**Chineham Court**
**Basingstoke,**
**Hampshire RG24 8AG (GB)**

(56) References cited:
**US-A- 4 893 349**　　**US-A- 5 408 693**

• **PATENT ABSTRACTS OF JAPAN vol. 2000, no. 01, 31 January 2000 (2000-01-31) & JP 11 284529 A (HITACHI DENSHI LTD), 15 October 1999 (1999-10-15)**
• **PATENT ABSTRACTS OF JAPAN vol. 014, no. 444 (E-0982), 21 September 1990 (1990-09-21) & JP 02 174431 A (TOSHIBA CORP;OTHERS: 01), 5 July 1990 (1990-07-05)**

## Description

Field of the Invention

The present invention generally relates to radio receivers, and particularly, to receivers having an audio signal attenuator function.

Background of the Invention

A radio receiver is known from US-A-4,893,349 that comprises a receiver unit operable to demodulate a RF (radio frequency) signal into an audio signal for forwarding to an electro-acoustic transducer and to provide a strength signal that has a magnitude proportional to the field strength of the RF signal; an attenuator operable to attenuate the audio signal; and an analyser operable to provide a control signal which controls the attenuator, the analyzer including a differentiator which is operable to produce a signal which represents the rate of change of the strength signal and an event detector which is operable to determine when a first event occurs when the magnitude of the strength signal is less than a pre-determined threshold value. The receiver is designed to eliminate bursts and pops in a received signal due to Rayleigh fading. It is therefore a relatively complex arrangement, which includes other functional components such as an envelope detector and a clipper.

The purpose of the invention is to improve another kind of receiver wherein another form of noise is required to be eliminated, namely demodulator noise when no received signal is present.

Detailed Description of the Drawings

FIG. 1    illustrates a simplified time diagram of an audio signal before and behind a mute switch in a known receiver, indications of the presence or absence of an RF carrier, and indications of the switch positions;

FIG. 2    illustrates a simplified block diagram of a receiver according to a first embodiment of the present invention;

FIG. 3    illustrates a simplified block diagram of a receiver according to a second embodiment of the present invention;

FIG. 4    illustrates a simplified a simplified block diagram of a microprocessor controlled receiver in a third embodiment of the present invention;

FIG. 5    illustrates a simplified time diagram of a strength signal used in the embodiments of the invention; and

FIG. 6    illustrates a simplified time diagram in comparison to the time diagram of FIG. 1.

Detailed Descriptionof Embodiments of the Invention

The present invention is concerned with operating an attenuator in the form of a mute switch which is employed to eliminate an unwanted audio signal due to modulator noise when no received signal is present. Use of a mute switch to eliminate an audio signal due to modulator noise is known per se as follows.

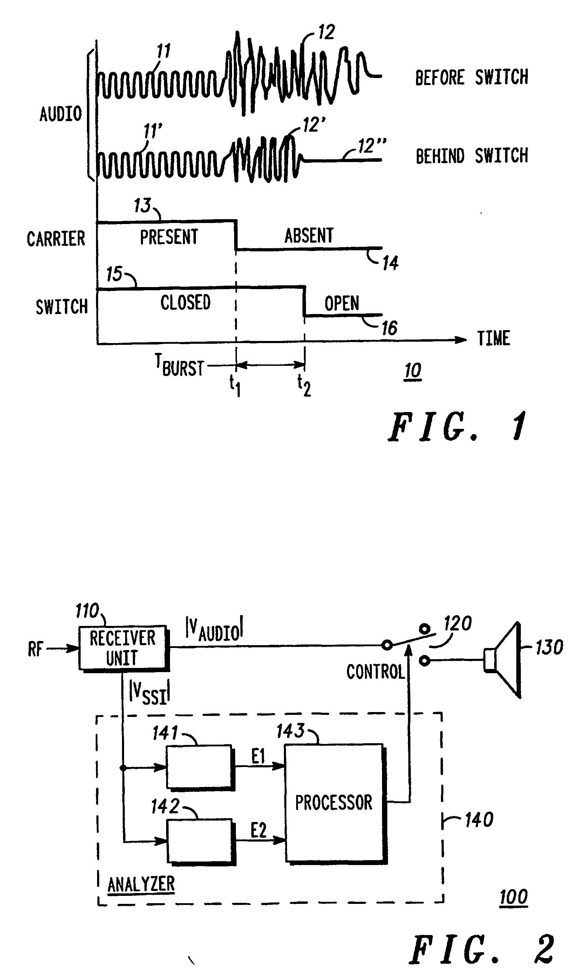

FIG. 1 illustrates a simplified time diagram 10 relating to such a known use of a mute switch. An audio signal before (11,12) and behind (11, 12', 12") the mute switch, indications of the presence 13 or absence 14 of a carrier in the RF signal, and indications of the switch positions closed 15 and open 16 of the mute switch.

Until a time $t_1$ the carrier is present 13, the audio signal before and behind the closed switch is a useful signal, e.g., voice, music, or data (hereinafter collectively "voice") as indicated by traces 11 and 11', respectively. When at $t_1$ the carrier becomes absent 14, the audio signal becomes noise 12. Since the switch is still closed, the speaker outputs noise burst 12' ("noise tail"). Often, noise burst 12' has a signal magnitude that is, in average over the time, higher (e.g., 1.5 times) that the average magnitude of voice 11'.

After detecting the noise, a squelch circuit opens the switch at $t_2$. Hence, speaker outputs noise burst 12' followed by substantial silence 12". For correctly detecting noise 12, the squelch circuit constantly integrates the audio signal. The burst duration $T_{BURST}$ from $t_1$ to $t_2$ (between 50 and 60 or more milli seconds) is related to integration constants that are multiple (e.g., 1000) of the shortest periods of voice 11 and noise 12 (e.g., $\geq 0.1$ milli second for a $\leq 10$ kHz signal).

FIG. 2 illustrates a simplified block diagram of an improved receiver 100 including a mute switch operated according to a first embodiment of the present invention. Receiver 100 comprises receiver unit 110, mute switch 120, electro-acoustic transducer 130 (e.g., speaker), and analyzer 140 (dashed frame). Preferably, analyzer 140 is implemented with event detectors 141 and 142 as well as AND-gate 143. The radio frequency (RF) signal arrives at receiver unit 110 via an antenna (not shown) or via further RF circuitry.

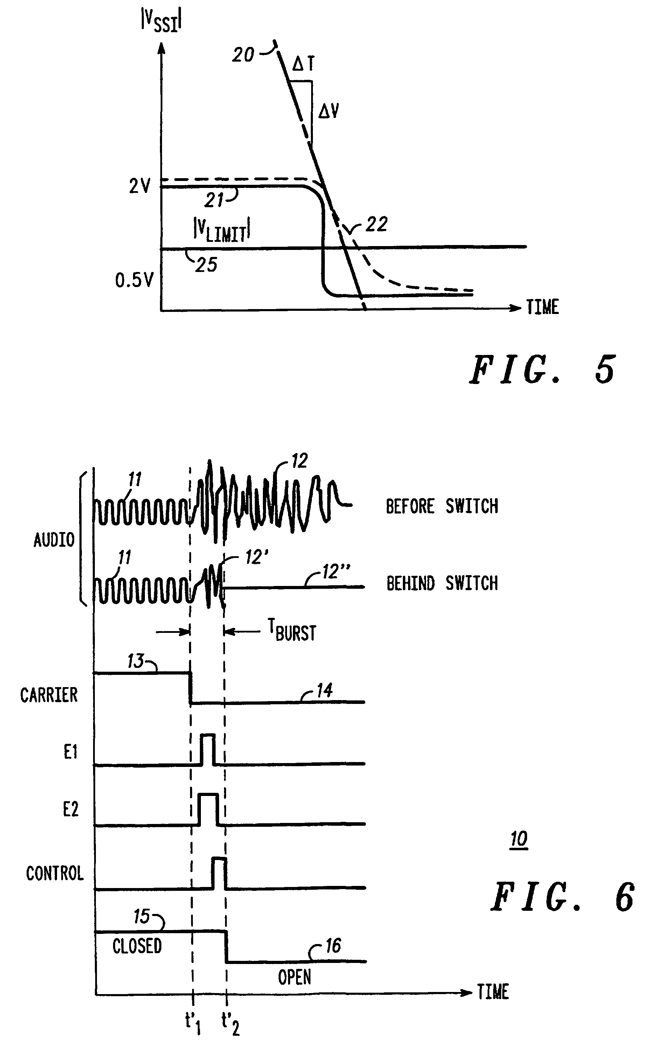

Receiver unit 110 demodulates the radio frequency (RF) signal into audio signal $|V_{AUDIO}|$ and provides a strength signal $|V_{SSI}|$ that is, preferably, a Signal Strength Indicator (SSI). A time diagram for $|V_{SSI}|$ is explained in connection with FIG. 5.

Mute switch 120 selectively forwards the audio signal to analyzer 140 which identifies first (1) and second (2) events and causes mute switch 120 to open when both events (1)(2) occur simultaneously.

The first event (1) occurs when the change rate of the magnitude of the strength signal is larger than a predetermined threshold change rate (e.g. expressed in milli volt per milli second), that is

$$|dV_{SSI}/dt| > |\Delta V/\Delta T| \qquad (1)$$

The symbol | | indicates absolute values.

The second event (2) occurs when the magnitude of the strength signal ($|V_{SSI}|$) goes below a predetermined threshold signal (e.g., expressed in milli volt), that is

$$|V_{SSI}| \leq |V_{LIMIT}|, \qquad (2)$$

In analyzer 140, detectors 141 and 142 issue first (E1) and second (E2) event signals (e.g., logical "1" for occurrence, "0" for non-occurrence), respectively. AND-gate 143 conjunctively relates event signals E1 and E2 to control signal CONTROL for mute switch 120, that is

$$CONTROL = E1 \ AND \ E2. \qquad (3)$$

For example, mute switch 120 opens if CONTROL toggles to logical "1" and closes if CONTROL toggles to logical "0". Persons of skill in the art can modify the logic, for example, by using Morgan's rules, without departing from the scope of the present invention.

Preferably, receiver 100 provides the strength signal $|V_{SSI}|$ by rectifying the RF signal (e.g., half wave rectification). Hence, the DC part of $|V_{SSI}|$ is proportional to the field strength of the RF signal. Rectifying the RF signal with an averaging time constant $\tau_{SSI}$ between 10 to 10.000 signal periods is convenient.

Strength signal $|V_{SSI}|$ can be an analog signal; having it represented as a voltage is convenient for explanation, but not essential for the present invention, it can also be represented as a current. The strength signal $|V_{SSI}|$ can also be represented in a digital form.

In an SSI estimate, receiver unit 110 measures the level of the received signal on the desired RF frequency. This measurement provides a summation of signal levels including the desired information signal, the co-channel interference, and the noise on the desired RF channel.

For FM receivers, it is convenient if receiver unit 110 derives $|V_{SSI}|$ from an RF signal being the intermediate frequency (IF) signal, for example, in the 10.7 mega hertz (MHz) band.

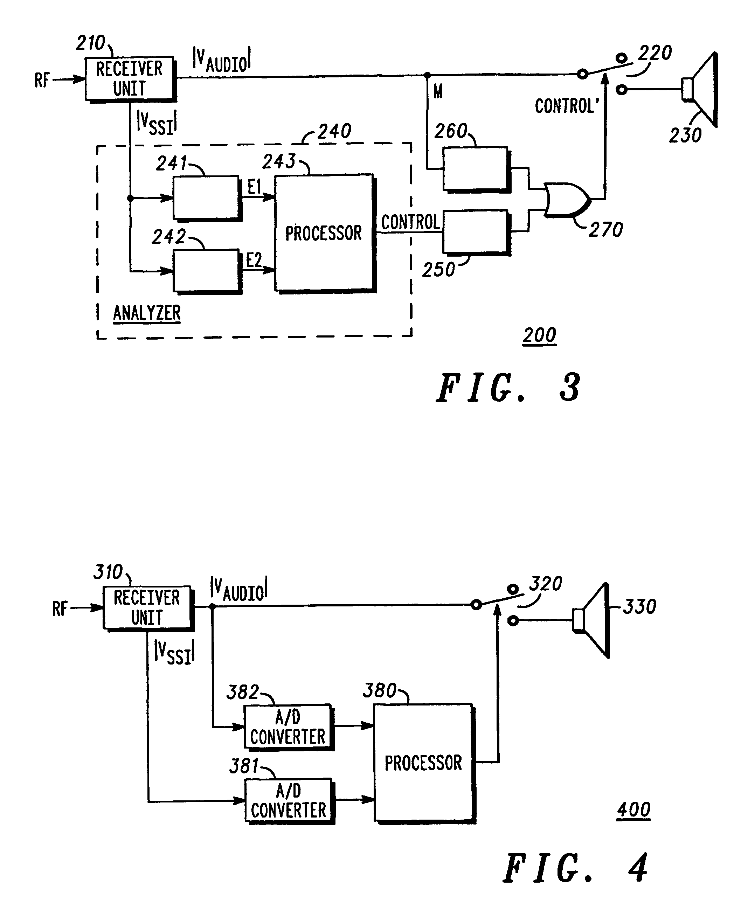

FIG. 3 illustrates a simplified block diagram of receiver 200 according to a second embodiment of the present invention. In FIGS. 2-3, reference numbers 100/200, 110/210, 120/220, 130/230, 140/240, 141/241, 142/242, 143/243, and symbols E1, E2, $|V_{SSI}|$, $|V_{AUDIO}|$ and RF stand for analogous components or signals. Preferably, receiver 200 further comprises delay unit 250, OR-gate 270 and audio squelch detector 260.

Delay unit 250 keeps mute switch 220 opened for a predetermined mute time interval $T_{MUTE}$ after analyser 240 has detected the removal of the carrier signal from the RF signal. Preferably, $T_{MUTE}$ is longer than a conventional burst duration $T_{BURST}$ (cf. FIG. 1). In other words, delay unit 250 holds control signal CONTROL (AND-gate 240) in turn-off position (e.g., logical "1") for a predetermined mute time interval ($T_{MUTE}$).

Audio squelch detector 260 monitors audio signal $|V_{AUDIO}|$. Operating as in a conventional squelch circuit, detector 260 provides a further mute signal M to switch 220 (via OR-gate 270). OR-gate 270 combines signal M with control signal CONTROL so that the signal CONTROL' acting on switch 220 is obtained as

$$CONTROL' = CONTROL \ OR \ M \qquad (4)$$

FIG. 4 illustrates a simplified a simplified block diagram of a microprocessor controlled receiver 300 in a third embodiment of the present invention. In FIGS. 2-4, reference numbers 100/200/300, 110/210/310 (receiver unit), 120/220/320 (switch), 130/230/330 (speaker) stand for analogous components. Receiver 300 further comprises microprocessor 380 implementing the functions of analyzer 140/240 with event detectors 141/241, 142/242, AND-gate 143/243 (cf. FIG. 2), and optionally, delay unit 250, OR-gate 270 and audio squelch detector 260 (cf. FIG. 3). As indicated by analog-to-digital converters (ADCs) 381 and 382, processor 380 receives representations of $|V_{SSI}|$ and $|V_{AUDIO}|$, respectively, in digital form. Optionally, microprocessor 380 is a digital signal processor (DSP)

FIG. 5 illustrates a simplified time diagram of a strength signal $|V_{SSI}|$ used in the embodiments of the invention. While $|V_{SSI}|$ has convenient magnitudes in the range between 0.5 and 2 volt as indicated on the ordinate axis; $|\Delta V/\Delta T|$ has convenient values between 1 volt per second (for normal signal strength change while receiving a carrier) and 10.000 volt per second (when receiving comes to an end) as indicated by dashed-point line 20. However, other values can also be used. Line 25 in parallel to the abscissa axis indicates the predetermined threshold signal $|V_{LIMIT}|$. Bold line 21 indicates strength signal $|V_{SSI}|$ complying with both event conditions (1) and (2); dashed line 22 indicates strength signal $|V_{SSI}|$ not complying with any of the conditions.

FIG. 6 illustrates a simplified time diagram in comparison to the time diagram of FIG. 1. Reference numbers are as in FIG. 1. Additionally, FIG. 6 illustrates event signals E1 and E2 (cf. FIGS. 2-3) and signal CONTROL (cf. relation (3)). It is an advantage of the present invention that $T_{BURST}$ is shorter than for the prior art as represented by FIG. 1. As mentioned above, this is accomplished by primarily monitoring $|V_{SSI}|$ instead of monitoring $|V_{AUDIO}|$ only as in the known mute switch control arrangement.

## Claims

1. A receiver (100) comprising a receiver unit (100) operable to demodulate a RF (radio frequency) signal into an audio signal for forwarding to an electroacoustic transducer (130) and to provide a strength signal ($V_{SSI}$) that has a magnitude proportional to the field strength of the RF signal; an attenuator operable to attenuate the audio signal; and an analyser operable to provide a control signal which controls the attenuator, the analyzer including a differentiator which is operable to produce a signal which represents the rate of change of the strength signal and an event detector (142) which is operable to determine when a first event occurs when the magnitude of the strength signal is less than a predetermined threshold value, and **characterised in that** the attenuator comprises a mute switch (120) operable to switch the audio signal on and off, and that the analyser (140) includes a further event detector (141) operable to detect when a second event occurs when the rate of change of the magnitude of the strength signal is greater than a pre-determined rate of change and that the analyser includes an AND gate (143) operable to receive inputs from the event detectors and to produce the control signal to control the mute switch when both the event detectors indicate simultaneous occurrence of the first and second events.

2. The receiver according to claim 1 wherein the further event detector is operable to compare the rate of change of the magnitude of the strength signal with a pre-determined rate of change (20) which indicates when receiving has come to an end.

3. The receiver according to claim 1 or claim 2, the receiver being operable to eliminate audio signals due to demodulator noise during periods when the mute switch is open.

4. The receiver of claim 1, wherein said receiver unit provides said strength signal by rectifying said RF signal.

5. The receiver of claim 4, wherein said receiver unit provides said strength signal as a Relative Signal Strength Indicator (SSI) signal.

6. The receiver of claim 5, wherein said SSI signal is a voltage signal or a current signal.

7. The receiver of claim 1, wherein the RF signal is an intermediate frequency (IF) signal.

8. The receiver of claim 1 which is operable to keep said mute switch opened for a predetermined mute time interval ($T_{MUTE}$).

9. The receiver of claim 1, further comprising a delay unit (250) to hold said control signal in turn-off position for a predetermined mute time interval ($T_{MUTE}$).

10. The receiver of claim 1 further comprising an audio squelch detector (260) that monitors said audio signal and provides a further mute signal to said switch.

11. The receiver of claim 10 further comprising an OR-gate (270) to combine said further mute signal with said control signal.

12. The receiver of claim 1 wherein said analyzer is implemented by a microprocessor.

## Patentansprüche

1. Empfänger (100) mit einer Empfängereinheit (100), die zum Demodulieren eines HF-Signals (Hochfrequenz) in ein Audiosignal zum Weiterleiten an einen elektroakustischen Wandler (130) und zum Bereitstellen eines Stärkesignals ($V_{ssi}$), das eine Größe aufweist, die der Feldstärke des HF-Signals proportional ist, ausgelegt ist; mit einem Dämpfer, der zum Dämpfen des Audiosignals ausgelegt ist; und mit einem Analysator, der zum Bereitstellen eines Steuersignals ausgelegt ist, das den Dämpfer steuert, wobei der Analysator einen Differenzierer, der zum Erzeugen eines Signals ausgelegt ist, das die Änderungsrate des Stärkesignals darstellt, und einen Ereignisdetektor (142) umfasst, der zum Bestimmen, wann ein erstes Ereignis auftritt, wenn die Größe des Stärkesignals geringer als ein vorbestimmter Grenzwert ist, ausgelegt ist, **dadurch gekennzeichnet, dass** der Dämpfer einen Stummschalter (120) umfasst, der dazu ausgelegt ist, das Audiosignal an- und auszuschalten, und dass der Analysator (140) einen weiteren Ereignisdetektor (141) umfasst, der dazu ausgelegt ist, zu detektieren, wann ein zweites Ereignis auftritt, wenn die Änderungsrate der Größe des Stärkesignals größer ist als eine vorbestimmte Änderungsrate, und dass der Analysator ein AND-Gatter (143) umfasst, das dazu ausgelegt ist, Eingaben von den Ereignisdetektoren zu empfangen und das Steuersignal zu erzeugen, um den Stummschalter zu steuern, wenn beide Ereignisdetektoren das gleichzeitige Auftreten des ersten und zweiten Ereignisses anzeigen.

2. Empfänger nach Anspruch 1, wobei der weitere Ereignisdetektor dazu ausgelegt ist, die Änderungsrate der Größe des Stärkesignals mit einer vorbestimmten Änderungsrate (20) zu vergleichen, die anzeigt, wenn das Empfangen zu Ende gegangen ist.

**3.** Empfänger nach Anspruch 1 oder 2, wobei der Empfänger dazu ausgelegt ist, Audiosignale aufgrund von Demodulatorrauschen während Zeiträumen zu eliminieren, während derer der Stummschalter offen ist.

**4.** Empfänger nach Anspruch 1, wobei die Empfängereinheit das Stärkesignal durch das Gleichrichten des HF-Signals zur Verfügung stellt.

**5.** Empfänger nach Anspruch 4, wobei die Empfängereinheit das Stärkesignal als ein Relativ-Signalstärke-Indikator-Signal (SSI-Signal) zur Verfügung stellt.

**6.** Empfänger nach Anspruch 5, wobei das SSI-Signal ein Spannungssignal oder ein Stromsignal ist.

**7.** Empfänger nach Anspruch 1, wobei das HF-Signal ein IF-Signal ("IF = Intermediate Frequency"/Zwischenfrequenz) ist.

**8.** Empfänger nach Anspruch 1, der dazu ausgelegt ist, den Stummschalter für ein vorbestimmtes Stummzeitintervall ($T_{MUTE}$) geöffnet zu halten.

**9.** Empfänger nach Anspruch 1, der weiterhin eine Verzögerungseinheit (250) umfasst, um das Steuersignal für ein vorbestimmtes Stummzeitintervall ($T_{MUTE}$) in einer ausgeschalteten Position zu halten.

**10.** Empfänger nach Anspruch 1, der weiterhin einen Audio-Unterdrückerdetektor (260) umfasst, der das Audiosignal überwacht und dem Schalter ein weiteres Stummsignal zur Verfügung stellt.

**11.** Empfänger nach Anspruch 10, der weiterhin ein OR-Gatter (270) umfasst, um das weitere Stummsignal mit dem Steuersignal zu kombinieren.

**12.** Empfänger nach Anspruch 1, wobei der Analysator mittels eines Mikroprozessors implementiert ist.

**Revendications**

**1.** Récepteur (100) comprenant une unité réceptrice (100) actionnable pour démoduler un signal RF (radiofréquence) en un signal audio destiné à être transmis à un transducteur électro-acoustique (130), et pour délivrer un signal d'intensité ($V_{SSI}$) ayant une amplitude proportionnelle à l'intensité de champ du signal RF ; un atténuateur actionnable pour atténuer le signal audio ; et un analyseur actionnable pour délivrer un signal de commande qui contrôle l'atténuateur, l'analyseur comprenant un différenciateur actionnable pour produire un signal qui représente la vitesse de changement du signal d'intensité, et un détecteur d'événement (142) actionnable pour déterminer lorsqu'un premier événement se produit quand l'amplitude du signal d'intensité est inférieure à une valeur de seuil prédéterminée, et **caractérisé en ce que** l'atténuateur comprend un commutateur Muet (120) actionnable pour activer et désactiver le signal audio, et **en ce que** l'analyseur (140) comprend un autre détecteur d'événement (141) actionnable pour détecter lorsqu'un second événement se produit quand la vitesse de changement d'amplitude du signal d'intensité est supérieure à une vitesse de changement prédéterminée, et **en ce que** l'analyseur comprend une porte ET (143) actionnable pour recevoir les entrées issues des détecteurs d'événements et pour produire le signal de commande pour commander le commutateur Muet lorsque les deux détecteurs d'événements indiquent l'apparition simultanée des premier et second événements.

**2.** Récepteur selon la revendication 1 dans lequel l'autre détecteur d'événement est actionnable pour comparer la vitesse de changement de l'amplitude du signal d'intensité à une vitesse de changement prédéterminée (20) qui indique lorsque la réception a pris fin.

**3.** Récepteur selon la revendication 1 ou 2, ce récepteur étant actionnable pour éliminer les signaux audio dus au bruit du démodulateur durant les périodes où le commutateur Muet est ouvert.

**4.** Récepteur selon la revendication 1, dans lequel ladite unité réceptrice délivre ledit signal d'intensité en rectifiant ledit signal RF.

**5.** Récepteur selon la revendication 4, dans lequel ladite unité réceptrice délivre ledit signal d'intensité en tant que signal Indicateur d'Intensité de Signal Relative (SSI).

**6.** Récepteur selon la revendication 5, dans lequel ledit signal SSI est un signal de tension ou un signal de courant.

**7.** Récepteur selon la revendication 1, dans lequel le signal RF est un signal de fréquence intermédiaire (FI).

**8.** Récepteur selon la revendication 1 qui est actionnable pour maintenir ledit commutateur Muet ouvert durant un intervalle de temps d'état muet prédéterminé ($T_{MUTE}$).

**9.** Récepteur selon la revendication 1, comprenant en outre une unité de retard (250) pour maintenir ledit signal de commande en position désactivée durant un intervalle de temps d' état muet prédéterminé (T$_{MUTE}$).

10. Récepteur selon la revendication 1 comprenant en outre un détecteur audio de suppression de bruit audio (260) qui surveille ledit signal audio et délivre un autre signal Muet audit commutateur.

11. Récepteur selon la revendication 10 comprenant en outre une porte OU (270) pour combiner ledit autre signal Muet avec ledit signal de commande.

12. Récepteur selon la revendication 1 dans lequel ledit analyseur est mis en oeuvre par un microprocesseur.

**BEFORE SWITCH**

**BEHIND SWITCH**

AUDIO

CARRIER
PRESENT · ABSENT

SWITCH
CLOSED · OPEN

TIME

$T_{BURST}$

$t_1$ $t_2$

$\underline{10}$

# FIG. 1

RF → RECEIVER UNIT

$|V_{AUDIO}|$

$|V_{SSI}|$

CONTROL

E1

E2

PROCESSOR

ANALYZER

$\underline{100}$

# FIG. 2

*FIG. 3*

*FIG. 4*

*FIG. 5*

*FIG. 6*